# FASCICULE DE BREVET EUROPEEN

(11) **EP 4 449 234 B1**
(45) Date de publication et mention de la délivrance du brevet: **25.11.2026**
(21) Numéro de dépôt: 22840265.7
(22) Date de dépôt: 13.12.2022
(51) Int. Cl.: G06F 3/01, B06B 1/02, B06B 1/06, G06F 3/0354

(54) **DISPOSITIF DE MODULATION DE FRICTION LOCALISÉE PAR VIBRATIONS DANS UNE INTERFACE VIBRANTE À SURFACE DE CONTACT**
VORRICHTUNG ZUR LOKALEN REIBUNGSMODULATION ÜBER VIBRATIONEN IN EINER VIBRIERENDEN SCHNITTSTELLE MIT EINER KONTAKTFLÄCHE
DEVICE FOR LOCALIZED FRICTION MODULATION VIA VIBRATIONS IN A VIBRATING INTERFACE WITH A CONTACT SURFACE

(30) Priorité: 14.12.2021 FR 2113426
(43) Date de publication de la demande: 23.10.2024
(73) Titulaire: Commissariat à l'Energie Atomique et aux Energies Alternatives, 75015 Paris (FR)
(72) Inventeur: BEN DHIAB, Ayoub, 91191 Gif-sur-Yvette Cedex (FR); HUDIN, Charles, 91191 Gif-sur-Yvette Cedex (FR)
(74) Mandataire: Bonnet, Michel
(86) Numéro de dépôt international: PCT/FR2022/052329
(87) Numéro de publication internationale: WO 2023/111444

(56) Documents cités:
- EP-B1- 3 446 195
- WO-A1-2018/178582
- US-A1- 2011 012 717
- US-A1- 2014 062 910

## Description

La présente invention concerne un dispositif de modulation de friction localisée par vibrations.

L'invention s'applique plus particulièrement à un dispositif comportant :
- une interface vibrante à surface de contact ;
- plusieurs actionneurs à surfaces actives disposées contre cette interface vibrante, conçus pour mettre en vibration l'interface vibrante dans une direction transversale par l'émission d'ondes mécaniques de flexion pour créer au moins une modulation de friction localisée sur la surface de contact ; et
- un générateur de plusieurs signaux de commande des actionneurs.

Un domaine d'application concerne la lubrification acoustique d'une surface de contact haptique d'une interface interactive, auquel cas les actionneurs sont à émission d'ondes acoustiques, de préférence ultrasonores. La lubrification acoustique consiste ainsi généralement à faire vibrer la surface de contact à une fréquence ultrasonore. Cette vibration, d'une amplitude de l'ordre du micron, engendre un contact intermittent entre un membre sensible au toucher d'un utilisateur, par exemple l'un quelconque de ses doigts, et la surface de contact, ce qui se traduit par une diminution significative du coefficient de friction apparent et facilite le déplacement du doigt sur la surface de contact. On peut ainsi également restituer la sensation d'une texture lors de l'exploration tactile d'une surface pourtant lisse. En modulant cet effet selon la position sur la surface de contact, on peut en outre donner l'illusion d'une variation spatiale de la friction et donc de la texture.

Un autre domaine d'application est la micromanipulation par acoustophorèse, selon laquelle des particules sont déplacées par la génération de vibrations localisées sur la surface de contact d'un support vibrant, auquel cas les actionneurs sont également à émission d'ondes acoustiques. Dans la suite de la description, on se concentrera principalement sur la lubrification acoustique, sachant que les principes généraux de la présente invention s'appliquent sans adaptation particulière à l'acoustophorèse et à d'autres domaines techniques où la modulation de friction localisée est envisageable.

Dans les mises en œuvre les plus courantes cependant, la fréquence acoustique utilisée correspond à une fréquence de résonance de l'interface vibrante. On obtient ainsi une grande amplitude de vibration mais un effet de lubrification acoustique identique sur toute la surface de contact. L'effet de texture provient donc d'une modulation temporelle corrélée au mouvement d'un doigt et non d'une variation spatiale de la friction. La conséquence est que plusieurs doigts en contact avec la surface sont soumis à un même stimulus et donc à une même sensation de texture. Cette approche est donc réservée à une exploration tactile à un seul doigt.

Une solution alternative à la modulation de friction par vibrations est la modulation électrostatique. Elle consiste à appliquer un potentiel électrique à une électrode disposée sous la surface de contact et séparée du ou des doigts de l'utilisateur par une couche mince isolante d'interface vibrante. Le corps humain étant à un autre potentiel électrique que celui de l'électrode, il existe une différence de potentiel à travers l'isolant et l'épiderme qui crée une force d'attraction électrostatique. En augmentant la force de contact, on augmente la force de friction et on crée l'illusion d'une surface de contact texturée. Cet effet étant localisé précisément au-dessus de l'électrode, on peut aisément placer un réseau d'électrodes sous la surface de contact et contrôler localement la modulation de friction pour une variation spatiale de cette dernière et une exploration multidigitale (de l'anglais « multitouch »).

Cette technologie pose toutefois des problèmes de sécurité, liés aux fortes tensions nécessaires à la finesse de la couche mince isolante. L'effet d'attraction électrostatique présente en outre l'inconvénient d'être très dépendant du potentiel électrique de l'utilisateur et de la résistance électrique de la peau qui varie beaucoup dans le temps et d'une personne à l'autre.

La modulation de friction par vibrations reste donc la technologie la plus satisfaisante, sous réserve qu'il soit possible de la localiser sur la surface de contact et de la faire varier spatialement pour une exploration multidigitale. C'est précisément un enseignement du document de brevet publié sous le numéro WO 2018/178582 A1 et de l'article de Charles Hudin, intitulé « Local friction modulation using non-radiating ultrasonic vibrations », publié à l'occasion de la conférence IEEE World Haptics Conference qui s'est tenue à Munich (DE) du 6 au 9 juin 2017, que de permettre astucieusement une localisation de la modulation de friction.

Selon cet enseignement, chaque signal de commande comporte un signal porteur à une fréquence non rayonnante pour l'actionneur qu'il commande. Par « fréquence non rayonnante », on entend une fréquence engendrant, en dehors d'une zone de la surface de contact couverte par cet actionneur, des interférences destructrices des ondes mécaniques de flexion émises de sorte que l'amplitude des vibrations engendrées par cet actionneur en dehors de la zone couverte est inférieure d'au moins 10 dB, avantageusement d'au moins 80 dB et de préférence même d'au moins 100 dB, à l'amplitude maximale des vibrations engendrées par cet actionneur dans la zone couverte, notamment en son centre.

De telles émissions non rayonnantes sont décrites dans d'autres domaines de la physique des ondes progressives et évanescentes, en acoustique et électromagnétisme notamment. L'enseignement précité consiste à utiliser ces émissions non rayonnantes pour moduler localement le coefficient de friction apparent en surface d'une interface vibrante.

Comme cela est bien connu, la fréquence porteuse non rayonnante d'un signal de commande pour un actionneur donné est indépendante de l'étendue et des conditions aux limites de l'interface vibrante contre laquelle cet actionneur est disposé. Elle dépend de l'épaisseur de cette interface, de ses propriétés mécaniques telles que le module d'Young, le coefficient de Poisson et la masse volumique, ainsi que des propriétés mécaniques et des dimensions de l'actionneur. Elle peut prendre une infinité de valeurs données théoriquement par la résolution d'un système d'équations à quatre inconnues résultant de solutions axisymétriques de l'équation de propagation des ondes de flexion dans une plaque mince.

Plus précisément, l'espace est divisé en deux zones pour la réalisation de ce calcul : la première est celle couverte par l'actionneur qui est considéré comme circulaire ; la deuxième est celle qui est extérieure à la première ; la frontière entre ces deux zones est la périphérie circulaire de l'actionneur. Dans chacune des deux zones, le déplacement hors plan des ondes de flexion est défini par l'équation de propagation de Kirchhoff-Love. L'actionneur étant circulaire et la plaque pouvant être considérée comme infinie, on ne considère que les solutions de cette équation qui sont axisymétriques et qui prennent une valeur finie au centre de l'actionneur et lorsque la distance à l'actionneur tend vers l'infini. Il reste alors quatre constantes à déterminer : deux décrivant le champ de vibrations dans la première zone et deux dans la deuxième zone. Ces quatre constantes sont liées par quatre équations de continuité à la frontière entre les deux zones : continuité du déplacement, continuité de sa dérivée, continuité du moment de flexion et continuité de l'effort tranchant. Selon le modèle connu « pin force » tel que notamment décrit par Victor Giurgiutiu dans plusieurs de ses articles ou ouvrages, la commande de l'actionneur par un signal de tension V crée un moment de flexion M sur sa périphérie circulaire qui s'ajoute à ceux de l'interface vibrante. On obtient finalement un système de quatre équations à quatre inconnues. En résolvant numériquement ce système, on obtient les quatre constantes à déterminer et donc l'allure du champ de vibrations à l'intérieur et à l'extérieur de l'actionneur. L'une de ces constantes correspond à l'amplitude de l'onde rayonnée. Les fréquences non rayonnantes sont celles qui annulent cette constante.

Il est alors à la portée de l'homme du métier de démontrer que, dans le cas d'un actionneur piézoélectrique circulaire suffisamment mince par rapport à l'épaisseur de l'interface vibrante contre laquelle il est disposé pour que sa raideur et sa masse soient négligeables devant celles de l'interface vibrante, la résolution analytique de ce système d'équations produit l'équation (1) suivante qui donne les valeurs possibles f de fréquences porteuses non rayonnantes pour cet actionneur : $f = \frac{1}{2 π} \sqrt{\frac{D}{{ρ}_{s}}} {\left(\frac{α}{R}\right)}^{2} ,$
où R est le rayon de l'actionneur circulaire, D est la constante de rigidité de l'interface vibrante, ρₛ est sa masse par unité de surface et α est une constante qui prend a *priori* une infinité de valeurs discrètes (3,83 ; 7,02 ; 10,17 ; ...) correspondant à autant de fréquences porteuses non rayonnantes. Cette constante α correspond aux valeurs x qui annulent la fonction de Bessel de première espèce d'ordre 1, J1(x). Il en existe une infinité. En pratique, il est avantageux de sélectionner la première valeur de fréquence non rayonnante située dans le domaine des ultrasons, c'est-à-dire au-delà de 16 kHz, voire au-delà de 20 kHz.

Le problème de cette approche est que l'amplitude de vibration de chaque actionneur décroît de manière sensible à l'intérieur même de la zone qu'il couvre, depuis son centre vers ses bords. Ainsi, même lorsque plusieurs actionneurs se touchent bords à bords, notamment même lorsqu'ils sont hexagonaux et disposés en nid d'abeilles, en glissant un doigt au-dessus de deux actionneurs voisins qui se touchent, on perçoit une zone de transition où la modulation de friction est plus faible.

Une solution intuitive serait de diminuer la taille des actionneurs, de sorte que la zone de contact entre le doigt et l'interface vibrante couvre plusieurs actionneurs, lissant ainsi les discontinuités. Mais, comme le montre l'équation (1) ci-dessus, la fréquence non rayonnante est inversement proportionnelle au carré du rayon de l'actionneur auquel elle s'applique. Diminuer la taille des actionneurs impose par conséquent d'augmenter significativement la fréquence de fonctionnement du dispositif et donc d'augmenter le courant d'alimentation et la puissance consommée. Pour rester dans des gammes de puissances acceptables, la taille de chaque actionneur doit rester à l'échelle de la pulpe d'un doigt de sorte que cette solution intuitive s'avère inapplicable.

Il peut ainsi être souhaité de prévoir un dispositif de modulation de friction localisée par vibrations qui permette de s'affranchir d'au moins une partie des problèmes et contraintes précités.

Il est donc proposé un dispositif de modulation de friction localisée par vibrations, comportant :
- une interface vibrante à surface de contact ;
- plusieurs actionneurs à surfaces actives disposées contre cette interface vibrante, conçus pour mettre en vibration l'interface vibrante dans une direction transversale par l'émission d'ondes mécaniques de flexion pour créer au moins une modulation de friction localisée sur la surface de contact ; et
- un générateur de plusieurs signaux de commande des actionneurs ;

dans lequel chaque signal de commande comporte un signal porteur à une fréquence non rayonnante pour l'actionneur qu'il commande ; et
dans lequel au moins deux des actionneurs présentent une portion commune de leurs surfaces actives en superposition.

Ainsi, en superposant les surfaces actives de plusieurs actionneurs voisins, il est possible de créer un champ de vibrations plus constant, sans zone morte de transition entre actionneurs dans laquelle la modulation de friction est ressentie comme plus faible. En pratique, cela ne se fait généralement pas en superposant mécaniquement des actionneurs indépendants, ce qui est difficile à réaliser, mais en superposant les motifs d'électrodes qui reçoivent les signaux de commande.

Par ailleurs, il convient de noter que dans les applications visées, les tensions d'alimentation et amplitudes des signaux de commande restent suffisamment faibles pour considérer les recouvrements comme linéaires. Dans ce cas, l'amplitude de vibration est localement proportionnelle à la tension de commande et le champ de vibrations produit par plusieurs actionneurs qui se recouvrent résulte localement de la somme des contributions individuelles des signaux qui les commandent.

De façon optionnelle, les actionneurs sont disposés en un double pavage de leurs surfaces actives circulaires de même rayon R :
- un premier pavage matriciel dans lequel chaque surface active touche sa ou ses voisine(s) en un point ;
- un deuxième pavage matriciel identique mais superposé au premier par décalage d'une distance égale au rayon R dans les deux directions en lignes et colonnes du premier pavage matriciel.

De façon optionnelle également, les actionneurs sont disposés en un triple pavage de leurs surfaces actives hexagonales de même longueur L de chaque côté d'hexagone :
- un premier pavage en nid d'abeilles dans lequel chaque surface active touche sa ou ses voisine(s) sur un côté ;
- deux autres pavages en nid d'abeilles identiques mais superposés au premier par décalage d'une distance égale à la longueur L dans deux des trois directions définies par les hexagones du premier pavage en nid d'abeilles.

De façon optionnelle également, la superposition de pavages constitue des portions de surfaces actives juxtaposées, chacune appartenant à un ou plusieurs actionneur(s), et matérialisées par une couche d'électrodes à raison d'une électrode par portion de surface active, chaque électrode étant alimentée par la contribution additive du ou des signaux de commande du ou des actionneur(s) associé(s) à la portion de surface active qu'elle matérialise.

De façon optionnelle également, chaque portion de surface active est triangulaire, formant ainsi une découpe triangulaire régulière d'électrodes résultant de la superposition des trois pavages en nid d'abeilles, et appartient à au plus trois actionneurs hexagonaux centrés respectivement au plus sur ses trois sommets par chacun desquels elle est combinée à cinq autres portions de surfaces triangulaires pour former chaque actionneur auquel elle appartient.

De façon optionnelle également, au moins deux actionneurs présentant une portion commune de leurs surfaces actives en superposition ont leurs signaux de commande respectifs engendrés en opposition de phases.

De façon optionnelle également, le générateur de signaux de commande est conçu pour engendrer des signaux périodiques centrés fréquentiellement sur leur fréquence non rayonnante et modulés à basse fréquence selon au moins une fréquence de modulation inférieure ou égale à 1 kHz.

De façon optionnelle également, chaque actionneur est couplé à un système de bascule à shunt passif.

De façon optionnelle également, les actionneurs comportent des transducteurs ultrasonores, notamment des transducteurs piézoélectriques ou magnétostrictifs.

De façon optionnelle également, l'interface vibrante comporte une plaque d'écran à technologie de diodes électroluminescentes organiques.

L'invention sera mieux comprise à l'aide de la description qui va suivre, donnée uniquement à titre d'exemple et faite en se référant aux dessins annexés dans lesquels :
- la figure 1 représente schématiquement en vue de côté la structure générale d'un dispositif de modulation de friction localisée par vibrations dans une interface vibrante à surface de contact, selon un mode de réalisation de l'invention,
- la figure 2 est un diagramme illustrant un exemple de réponse vibratoire d'un actionneur circulaire du dispositif de la figure 1 en fonction de la fréquence porteuse de son signal de commande,
- la figure 3A illustre un exemple de distribution spatiale de vibrations sur une surface de contact obtenue par activation d'un actionneur circulaire isolé du dispositif de la figure 1 à l'aide d'un signal de commande comportant un signal porteur de fréquence rayonnante,
- la figure 3B illustre un exemple de distribution spatiale de vibrations sur une surface de contact obtenue par activation d'un actionneur circulaire isolé du dispositif de la figure 1 à l'aide d'un signal de commande comportant un signal porteur de fréquence non rayonnante,
- la figure 4A illustre un exemple de distribution spatiale de vibrations sur une surface de contact obtenue par activation de deux actionneurs circulaires à l'aide de deux signaux de commande comportant chacun un signal porteur de fréquence non rayonnante, lorsque les deux actionneurs se touchent mais ne présentent pas de portion commune de leurs surfaces actives en superposition,
- la figure 4B illustre un exemple de distribution spatiale de vibrations sur une surface de contact obtenue par activation de trois actionneurs circulaires à l'aide de trois signaux de commande comportant chacun un signal porteur de fréquence non rayonnante, lorsque les trois actionneurs se touchent et présentent des portions communes de leurs surfaces actives en superposition deux à deux, selon une première variante de réalisation de la présente invention,
- la figure 4C illustre un exemple de distribution spatiale de vibrations sur une surface de contact obtenue par activation de trois actionneurs circulaires à l'aide de trois signaux de commande comportant chacun un signal porteur de fréquence non rayonnante, lorsque les trois actionneurs se touchent et présentent des portions communes de leurs surfaces actives en superposition deux à deux, selon une deuxième variante de réalisation de la présente invention,
- la figure 5 représente schématiquement en vue de face un exemple de disposition bidimensionnelle, conforme aux principes généraux de la présente invention, d'actionneurs circulaires contre une interface vibrante d'un dispositif de modulation de friction localisée par vibrations,
- la figure 6 représente schématiquement en vue de face un exemple de disposition bidimensionnelle, conforme aux principes généraux de la présente invention, d'actionneurs hexagonaux contre une interface vibrante d'un dispositif de modulation de friction localisée par vibrations,
- la figure 7A illustre un exemple de distribution spatiale de vibrations sur une surface de contact obtenue par activation de deux actionneurs hexagonaux à l'aide de deux signaux de commande comportant chacun un signal porteur de fréquence non rayonnante, lorsque les deux actionneurs se touchent et présentent une portion commune de leurs surfaces actives en superposition, selon une première variante de réalisation de la présente invention,
- la figure 7B illustre un exemple de distribution spatiale de vibrations sur une surface de contact obtenue par activation de deux actionneurs hexagonaux à l'aide de deux signaux de commande comportant chacun un signal porteur de fréquence non rayonnante, lorsque les deux actionneurs se touchent et présentent une portion commune de leurs surfaces actives en superposition, selon une deuxième variante de réalisation de la présente invention,
- la figure 8 illustre quatre exemples de distributions spatiales de vibrations sur une surface de contact obtenue par activation de plusieurs actionneurs hexagonaux à l'aide de signaux de commande comportant chacun un signal porteur de fréquence non rayonnante, lorsque les actionneurs se touchent et présentent des portions communes de leurs surfaces actives en superposition, selon plusieurs dispositions et nombres possibles de ces actionneurs, et
- la figure 9 représente schématiquement un circuit électrique de bascule à shunt passif pour un actionneur de dispositif de modulation de friction localisée par vibrations selon la présente invention.

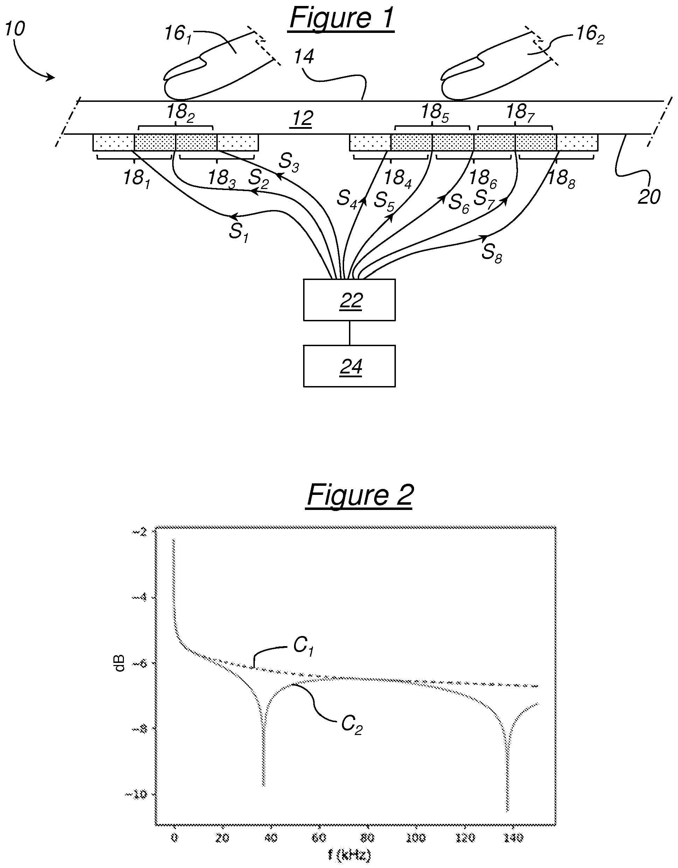

La représentation schématique très simplifiée d'un dispositif 10 de modulation de friction localisée par vibrations illustre en vue de côté sur la figure 1 une interface vibrante 12, par exemple une plaque d'écran OLED (de l'anglais « Organic Light-Emitting Diode », c'est-à-dire à technologie de diodes électroluminescentes organiques) tactile, présentant une surface supérieure de contact 14 sur laquelle peut glisser au moins un doigt 16₁, 16₂ d'un utilisateur, ou tout autre membre d'interaction sensible au toucher.

Dans l'exemple illustré la surface de contact 14 est plane mais elle peut prendre toute courbure souhaitée selon l'application visée, l'interface vibrante 12 pouvant elle-même être une coque tactile de n'importe quelle forme tridimensionnelle et de plusieurs matières telles que le verre, différents types de plastique, métal, céramique ou autres.

Plusieurs actionneurs 18₁, 18₂, 18₃, 18₄, 18₅, 18₆, 18₇, 18₈ sont disposés contre une surface inférieure 20, opposée à la surface supérieure de contact 14, de l'interface vibrante 12. Ils sont conçus pour mettre en vibration l'interface vibrante 12 dans une direction transversale par l'émission d'ondes mécanique de flexion pour créer au moins une modulation de friction localisée sur la surface de contact 14 lorsqu'ils sont excités par des signaux de commande. De façon connue en soi, cette mise en vibration est possible lorsque l'interface vibrante est suffisamment fine par rapport à ses propres dimensions latérales et aux dimensions des actionneurs, par exemple moins d'un millimètre d'épaisseur.

Ce sont par exemple des transducteurs ultrasonores piézoélectriques de 1 µm à 1 mm d'épaisseur, comportant chacun une couche de céramique, par exemple de type PZT (pour Titano-Zirconate de Plomb) ou AIN (pour Nitrure d'Aluminium), enserrée entre deux couches d'électrodes, l'une qualifiée d'électrode inférieure disposée au contact de la surface inférieure 20 et l'autre qualifiée d'électrode supérieure. Ils présentent ainsi chacun une surface active matérialisée par la surface commune de leurs électrodes inférieure et supérieure en vis-à-vis, cette surface active étant maintenue par l'électrode inférieure au contact de la surface inférieure 20 de l'interface vibrante 12 par exemple par collage ou dépôt en couches minces.

En variante, ils pourraient être magnétostrictifs auquel cas la surface active d'un tel transducteur est sa portion de surface externe au contact direct de la surface inférieure 20 de l'interface vibrante 12.

L'une des électrodes de chaque actionneur est reliée à la masse, c'est-à-dire à un potentiel de référence, tandis que l'autre est reliée à un générateur 22 de signaux de commande, lui-même alimenté par une source d'alimentation 24. Ce générateur 22 délivre par exemple autant de signaux de commande S₁, S₂, S₃, S₄, S₅, S₆, S₇, S₈ que d'actionneurs 18₁, 18₂, 18₃, 18₄, 18₅, 18₆, 18₇, 18₈. C'est généralement l'électrode inférieure qui est reliée à la masse et l'électrode supérieure qui est reliée au générateur 22 puisque c'est cette dernière qui est normalement la plus facilement accessible pour un raccord électrique individuel.

Chaque signal de commande Sᵢ comporte en régime harmonique un signal porteur à une fréquence non rayonnante pour l'actionneur 18ᵢ qu'il commande. Comme défini précédemment, il s'agit d'une fréquence engendrant, en dehors d'une zone de la surface de contact couverte par cet actionneur 18₁, c'est-à-dire précisément la zone de la surface de contact 14 qui est en vis-à-vis de la surface active de l'actionneur 18ᵢ et de même géométrie, des interférences destructrices des ondes mécaniques de flexion émises de sorte que l'amplitude des vibrations engendrées par cet actionneur en dehors de la zone couverte est inférieure d'au moins 10 dB, avantageusement d'au moins 80 dB et de préférence même d'au moins 100 dB, à l'amplitude maximale des vibrations engendrées par cet actionneur dans la zone couverte.

Le signal porteur de chaque signal de commande est par exemple sinusoïdal, ou plus généralement périodique et centré sur sa fréquence non rayonnante, laquelle est avantageusement ultrasonore, c'est-à-dire au-delà de 16 kHz, voire au-delà de 20 kHz. Chaque signal de commande peut en outre résulter d'une modulation à basse fréquence de son signal porteur, c'est-à-dire selon au moins une fréquence de modulation inférieure ou égale à 1 kHz. Une telle modulation dans la gamme de perception tactile permet de reproduire une texture particulière pour un retour haptique souhaité en supplément de la lubrification acoustique.

Par ailleurs, comme cela est visible sur la figure 1, au moins deux des actionneurs présentent une portion commune de leurs surfaces actives en superposition. Plus précisément, les actionneurs 18₁ et 18₂ se superposent, de même que les actionneurs 18₂ et 18₃. En revanche les actionneurs 18₁ et 18₃ se touchent mais ne se recouvrent pas. Il en résulte que les trois actionneurs 18₁, 18₂ et 18₃ forment une première zone d'interaction haptique localisée avec un premier doigt 16₁ d'utilisateur. Plus précisément également, les actionneurs 18₄ et 18₅ se superposent, de même que les actionneurs 18₅ et 18₆, 18₆ et 18₇, 18₇ et 18₈. En revanche les actionneurs 18₄ et 18₆ se touchent mais ne se recouvrent pas, de même que les actionneurs 18₆ et 18₈. Il en résulte que les cinq actionneurs 18₄, 18₅, 18₆,18₇ et 18₈ forment une deuxième zone d'interaction haptique localisée avec un deuxième doigt 16₂ d'utilisateur.

Les deux zones d'interaction haptique localisée ne se touchant pas nécessairement, l'interaction haptique peut être différente d'une zone à l'autre grâce à une différenciation des signaux de commande, notamment par leur modulation à basse fréquence. Il en résulte la possibilité d'une exploration multidigitale.

Le diagramme de la figure 2 illustre cette propriété de fréquences non rayonnantes qui existent pour un actionneur donné. La courbe C₁ en pointillés donne, en décibels par rapport à une amplitude de référence, l'évolution de l'amplitude des vibrations en flexion engendrées au centre de la surface active couverte par l'actionneur considéré en fonction de la fréquence porteuse du signal de commande qui l'active. La courbe C₂ en trait plein donne l'évolution de l'amplitude des vibrations en flexion engendrées à l'extérieur de la surface active couverte par l'actionneur considéré en fonction de la fréquence porteuse du signal de commande qui l'active. On voit que la courbe C₂ présente au moins deux fréquences non rayonnantes pour l'actionneur considéré, l'une à f₁ = 37,1 kHz et l'autre à f₂ = 137,7 kHz

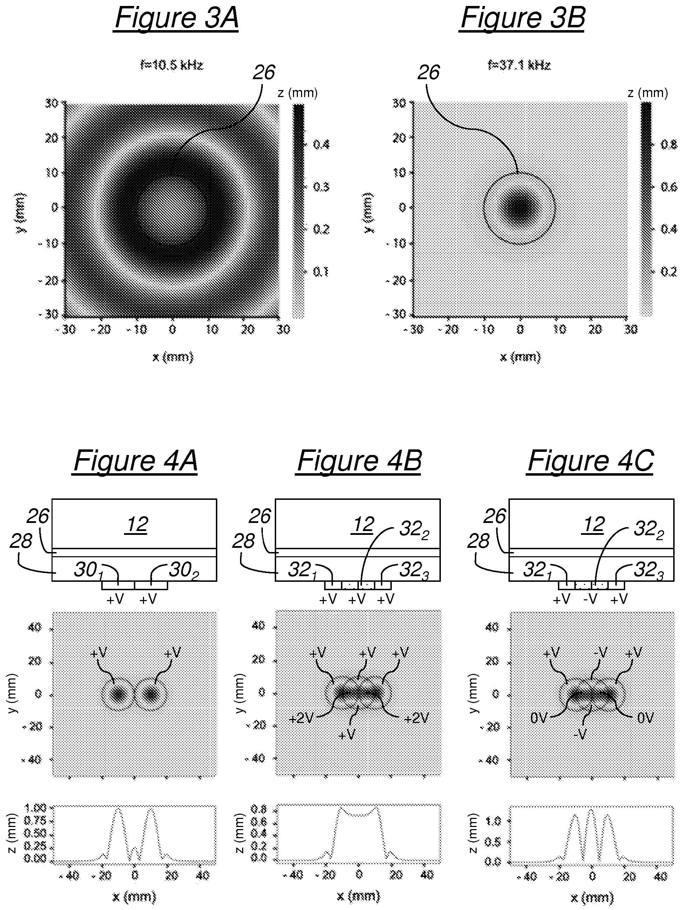

Ainsi, à une fréquence porteuse f rayonnante quelconque, par exemple égale à 10,5 kHz dans le diagramme de la figure 2, la figure 3A illustre une distribution spatiale de vibrations en flexion s'étendant jusqu'à 30 mm du centre d'un actionneur circulaire de 10 mm de rayon qui peut être obtenue sur la surface de contact 14 contre laquelle est disposé cet actionneur lorsqu'il est activé. Les vibrations débordent largement de la périphérie 26 de sa surface active, même au-delà des 30 mm représentés. Ce dernier peut être l'un quelconque des actionneurs de la figure 1.

Mais lorsque la fréquence porteuse f du signal de commande est précisément égale à f₁ = 37,1 kHz, donc non rayonnante, la figure 3B illustre la distribution spatiale résultante des vibrations en flexion jusqu'à 30 mm du centre du même actionneur. Elles ne sont plus visibles ni sensibles à l'extérieur de sa surface active. Elles sont même déjà fortement réduites avant d'atteindre la périphérie 26.

Ainsi, la figure 4A illustre la distribution spatiale de vibrations résultant de deux actionneurs circulaires tels que celui de la figure 3B disposés bords à bords, c'est-à-dire se touchant mais ne présentant pas de portion commune de leurs surfaces actives en superposition, lorsqu'ils sont respectivement activés à l'aide de deux signaux de commande identiques à fréquence porteuse f non rayonnante égale à f₁ = 37,1 kHz, d'amplitude commune +V et en phase. On observe en partie inférieure de la figure 4A que l'amplitude de vibration en flexion, le long de la normale z à la surface de contact 14, présente malheureusement une décroissance centrale prononcée et sensible au toucher entre les deux actionneurs, créant une zone de transition où la modulation de friction est plus faible.

On notera que dans cet exemple concret d'implémentation, chaque actionneur est un transducteur piézoélectrique défini et délimité par son électrode supérieure. En effet et comme cela est illustré en vue de côté en partie supérieure de la figure 4A, l'électrode inférieure 26 collée contre l'interface vibrante 12 est en fait commune aux deux actionneurs, de même que la couche de céramique 28. Deux électrodes supérieures adjacentes en forme de pastilles circulaires 30₁, 30₂ sont découpées dans une couche conductrice supérieure. Elles forment et délimitent les surfaces actives des deux actionneurs. En variante, chaque actionneur pourrait avoir sa propre électrode inférieure et sa propre couche de céramique, seule comptant dans le contexte de la présente invention la différence de potentiel entre les deux électrodes d'un même actionneur.

Conformément aux principes généraux de la présente invention, la figure 4B illustre la distribution spatiale de vibrations résultant de plusieurs actionneurs tels que celui de la figure 3B dont au moins deux présentent avantageusement une portion commune de leurs surfaces actives en superposition, lorsqu'ils sont respectivement activés à l'aide de signaux de commande identiques à fréquence porteuse f non rayonnante égale à f₁ = 37,1 kHz. Plus précisément et à titre d'exemple simple purement illustratif, trois actionneurs circulaires tels que celui de la figure 3B sont disposés linéairement de telle sorte que le premier et le troisième sont bords à bords alors que le deuxième se superpose entre les deux autres. Le deuxième actionneur présente ainsi une première portion de surface active commune en superposition avec le premier actionneur, une deuxième portion de surface active commune en superposition avec le troisième actionneur et deux portions de surfaces actives sans superposition. Chacun des premier et troisième actionneurs conserve en outre une portion de surface active sans superposition.

Les trois actionneurs sont respectivement activés à l'aide de trois signaux de commande d'amplitude commune +V et en phase. Il en résulte, par propriété additive des contributions des signaux de commande, que les quatre portions de surfaces actives d'actionneurs non superposées sont alimentées en amplitude de commande +V alors que les deux portions de surfaces actives communes précitées sont alimentées en amplitude de commande +2V. Ainsi, On observe en partie inférieure de la figure 4B que l'amplitude de vibration en flexion, le long de la normale z à la surface de contact 14, ne présente plus de décroissance sensible au toucher entre les trois actionneurs, grâce à leur superposition deux à deux.

En variante, la figure 4C illustre la distribution spatiale de vibrations résultant de la même superposition de trois actionneurs que celle de la figure 4B, lorsqu'ils sont respectivement activés à l'aide de signaux de commande à la même fréquence porteuse f non rayonnante.

Mais le signal de commande du deuxième actionneur est en opposition de phase avec les deux autres. En d'autres termes, les premier et troisième signaux de commande sont d'amplitude commune +V et en phase, alors que le troisième signal de commande peut être considéré de même amplitude et en opposition de phase ou d'amplitude -V et en phase. Il en résulte que, par propriété additive des contributions des signaux de commande, les quatre portions de surfaces actives d'actionneurs non superposées sont alimentées en amplitude de commande +V alors que les deux portions de surfaces actives communes précitées sont alimentées en amplitude de commande 0V. Ainsi, On observe en partie inférieure de la figure 4C que l'amplitude de vibration en flexion, le long de la normale z à la surface de contact 14, présente deux décroissances entre les trois actionneurs. Mais elles sont si étroites qu'elles ne sont finalement pas sensibles au toucher, ou en tout cas nettement moins que dans le cas de la figure 4A.

On notera par ailleurs que dans l'exemple concret d'implémentation des figures 4B et 4C, chaque actionneur est un transducteur piézoélectrique défini et délimité par son électrode supérieure. Comme illustré en vue de côté en partie supérieure des figures 4B et 4C, l'électrode inférieure 26 collée contre l'interface vibrante 12 est commune aux trois actionneurs, de même que la couche de céramique 28. Trois électrodes supérieures superposées en forme de pastilles circulaires 32₁, 32₂, 32₃ sont découpées dans une couche conductrice supérieure et forment les surfaces actives des trois actionneurs, fonctionnellement alimentées respectivement par trois signaux de commande, identiques et en phase dans la variante de la figure 4B, identiques et avec le deuxième signal de commande en opposition de phase par rapport aux deux autres dans la variante de la figure 4C. En pratique et de façon parfaitement équivalente, ce sont en fait les six portions de surfaces actives juxtaposées qui sont avantageusement découpées dans la couche conductrice supérieure et alimentées par six signaux de commande. Les deux portions de surfaces actives en superposition sont respectivement alimentées à +2V et les quatre autres à +V dans la variante de la figure 4B, tandis qu'elles sont alimentées à 0V et les quatre autres à +V dans la variante de la figure 4C.

On observe ainsi que la variante de la figure 4C présente un profil de lubrification acoustique un peu moins performant que celui de la variante de la figure 4B (tout en restant nettement plus performant que celui de la figure 4A), mais avec un avantage clair en termes de niveaux de tension et consommation énergétique : pas d'alimentation des deux portions de surfaces actives en superposition dans la variante 4C, contre deux alimentations à +2V dans la variante 4B.

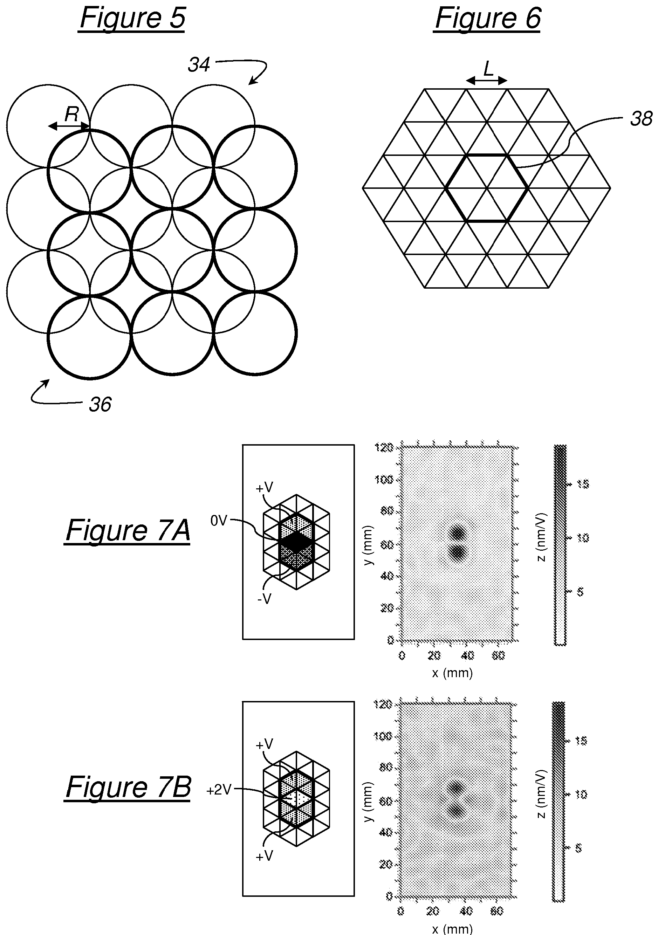

Conformément aux principes généraux de la présente invention, la figure 5 illustre en vue de face un exemple de disposition bidimensionnelle d'actionneurs circulaires superposés contre une interface vibrante telle que l'interface 12.

Plus précisément, les actionneurs sont disposés en un double pavage de leurs surfaces actives circulaires de même rayon R. Un premier pavage matriciel 34 dans lequel chaque surface active circulaire touche sa ou ses voisine(s) en un point est représenté en traits fins. Un deuxième pavage matriciel 36, identique mais superposé au premier par décalage d'une distance égale au rayon R dans les deux directions en lignes et colonnes du premier pavage matriciel 34, est représenté en traits épais. On remarque qu'en dehors des actionneurs situés aux bords des deux pavages 34 et 36, chaque actionneur circulaire de l'un des deux pavages 34 ou 36 présente cinq portions de surfaces actives ou électrodes juxtaposées formant le disque de l'actionneur, dont une centrale sans superposition et quatre périphériques en superposition chacune avec un actionneur voisin de l'autre des deux pavages 36 ou 34. En pratique, le motif résultant de portions de surfaces actives à découper dans la couche conductrice supérieure est assez complexe à réaliser, mais la forme circulaire des actionneurs résultants permet une optimisation de l'effet de la fréquence non rayonnante sur l'absence de vibrations à l'extérieur de la portion de surface de contact 14 à lubrifier acoustiquement.

Conformément aux principes généraux de la présente invention également, la figure 6 illustre en vue de face un exemple de disposition bidimensionnelle d'actionneurs hexagonaux superposés contre une interface vibrante telle que l'interface 12. La forme hexagonale est une bonne approximation de la forme circulaire pour conserver un effet acceptable de la fréquence non rayonnante sur la forte atténuation de vibrations à l'extérieur de la portion de surface de contact 14 à lubrifier acoustiquement. De ce point de vue, la forme hexagonale est sous-optimale. En revanche, du point de vue du pavage de la surface de contact 14 et de l'amplitude des vibrations que l'on peut obtenir, elle est optimale puisque chaque pavage en nid d'abeilles résultant d'une juxtaposition d'actionneurs hexagonaux couvre la totalité de la portion de surface de contact 14 à lubrifier.

Plus précisément, les actionneurs sont disposés en un triple pavage de leurs surfaces actives hexagonales de même longueur L de chaque côté d'hexagone. Dans un premier pavage en nid d'abeilles, chaque surface active hexagonale d'actionneur touche sa ou ses voisine(s) sur un côté. Les deux autres pavages en nid d'abeilles sont identiques mais superposés au premier par décalage d'une distance égale à la longueur L dans deux des trois directions définies par les hexagones du premier pavage en nid d'abeilles. On remarque qu'en dehors des actionneurs situés aux bords des pavages en nid d'abeilles, chaque actionneur hexagonal 38 de l'un quelconque des trois pavages présente six portions de surfaces actives ou électrodes juxtaposées triangulaires formant l'hexagone de l'actionneur, toutes en superposition chacune avec deux actionneurs voisins des deux autres pavages.

En pratique, le motif résultant des portions de surfaces actives à découper dans la couche conductrice supérieure est très simple à réaliser puisque chaque portion de surface active est triangulaire, formant ainsi une découpe triangulaire régulière d'électrodes supérieures résultant de la superposition des trois pavages en nid d'abeilles. Chaque portion de surface active appartient à au plus trois actionneurs hexagonaux centrés respectivement au plus sur ses trois sommets par chacun desquels elle est combinée à cinq autres portions de surfaces triangulaires pour former chaque actionneur auquel elle appartient.

On notera que dans les deux exemples des figures 5 et 6 la superposition des pavages constitue des portions de surfaces actives juxtaposées, chacune appartenant à un ou plusieurs actionneur(s), et matérialisées par une découpe spécifique de la couche conductrice supérieure d'électrodes précitée à raison d'une électrode par portion de surface active, chaque électrode étant alimentée par un signal de commande qui correspond à la contribution additive du ou des signaux de commande du ou des actionneur(s) associé(s) à la portion de surface active qu'elle matérialise. En particulier, le maillage triangulaire obtenu à l'aide d'actionneurs hexagonaux en nid d'abeilles sur trois pavages permet de les positionner virtuellement tous en regroupant les portions de surfaces triangulaires correspondantes par six.

Quelques exemples non limitatifs de distributions spatiales de vibrations pouvant être obtenues par superpositions d'actionneurs hexagonaux vont maintenant être illustrés.

La figure 7A illustre un exemple dans lequel deux actionneurs hexagonaux se superposent sur deux portions de surfaces actives triangulaires et sont commandés en opposition de phases. Ainsi les quatre portions de surfaces actives triangulaires sans superposition du premier actionneur hexagonal sont alimentées en +V (texturé en gris moyen), les quatre portions de surfaces actives triangulaires sans superposition du deuxième actionneur hexagonal sont alimentées en -V (texturé en gris foncé) et les deux portions de surfaces actives triangulaires en superposition sont alimentées en 0V (texturé en noir). On observe un motif de vibrations localisées assez homogène pour une consommation énergétique optimisée. Les dimensions latérales de la surface de contact sont exprimées en mm, tandis que les amplitudes de vibrations sont exprimées en nmN.

La figure 7B illustre un exemple dans lequel les deux mêmes actionneurs hexagonaux se superposent sur les deux mêmes portions de surfaces actives triangulaires et sont commandés en phase. Ainsi les quatre portions de surfaces actives triangulaires sans superposition du premier actionneur hexagonal sont alimentées en +V (texturé en gris moyen), les quatre portions de surfaces actives triangulaires sans superposition du deuxième actionneur hexagonal sont alimentées en +V (texturé en gris moyen) et les deux portions de surfaces actives triangulaires en superposition sont alimentées en +2V (texturé en gris clair). On observe un motif de vibrations localisées moins homogène que le précédent pour une consommation énergétique moins optimale. Les dimensions latérales de la surface de contact sont toujours exprimées en mm, tandis que les amplitudes de vibrations sont exprimées en nm/V.

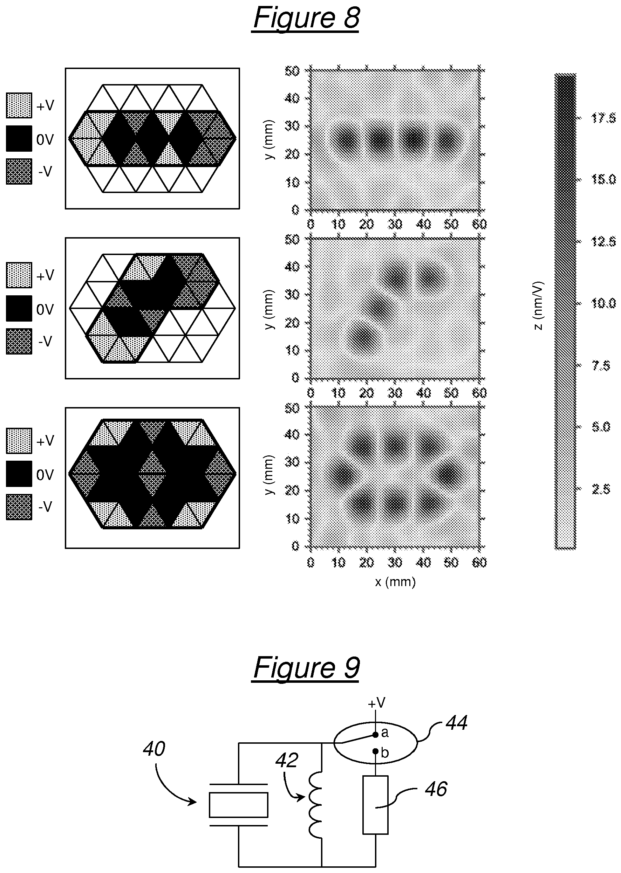

La figure 8 illustre trois autres exemples :
- un premier exemple de quatre actionneurs hexagonaux alignés en superposition et commandés en opposition de phases deux à deux, où les alimentations résultantes de portions de surfaces actives triangulaires sont indiquées en gris moyen pour +V, en gris foncé pour -V et en noir pour 0V,
- un deuxième exemple de quatre actionneurs hexagonaux en superposition et commandés en opposition de phases deux à deux, l'un d'entre eux n'étant pas aligné sur les trois autres, où les alimentations résultantes de portions de surfaces actives triangulaires sont indiquées en gris moyen pour +V, en gris foncé pour -V et en noir pour 0V, et
- un troisième exemple de huit actionneurs hexagonaux en superposition et commandés en opposition de phases deux à deux, disposés selon un arrangement oblong, où les alimentations résultantes de portions de surfaces actives triangulaires sont indiquées en gris moyen pour +V, en gris foncé pour -V et en noir pour 0V.

On observe des motifs de vibrations localisées assez homogènes pour une consommation énergétique optimale. Les dimensions latérales de la surface de contact sont exprimées en mm, tandis que les amplitudes de vibrations sont exprimées en nmN.

Compte tenu de la forme hexagonale des actionneurs dans les exemples des figures 7A, 7B et 8, des vibrations résiduelles restent malgré tout observables sur la surface de contact, bien que très atténuées, à l'extérieur des zones couvertes par les actionneurs activés par les signaux de commande.

Il est donc proposé de façon optionnelle d'utiliser les actionneurs restants, autrement dit ceux qui ne sont pas sollicités, pour atténuer de manière passive ces vibrations résiduelles. Pour cela, chaque actionneur est couplé à au moins un système de bascule à shunt passif. Plus précisément même, il est avantageux en pratique de coupler chaque électrode découpée dans la couche conductrice supérieure, c'est-à-dire chaque portion de surface active de chaque actionneur, à un système de bascule à shunt passif.

Un exemple simple d'un tel couplage est représenté schématiquement sous la forme d'un circuit électrique équivalent sur la figure 9. L'actionneur couplé, ou la portion de surface active d'actionneur couplée, y est modélisé par une capacité 40 à laquelle peut être optionnellement associée en parallèle une inductance 42. Cet ensemble est raccordé à une bascule ou commutateur 44 permettant, soit d'activer l'actionneur ou la portion de surface active d'actionneur en le ou la raccordant à un signal de commande (+V) selon une position a du commutateur 44, soit en le ou la court-circuitant selon une position b du commutateur 44 à travers une résistance dissipative 46 disposée en parallèle et formant le shunt passif.

En présence de l'inductance 42, le shunt passif est inductif. Sinon, il est purement résistif.

En notant C la valeur de la capacité 40 et L la valeur de l'inductance 42 lorsque cette dernière est ajoutée, l'impédance électrique équivalente Z de l'actionneur ou de la portion de surface active d'actionneur vaut : $Z = \frac{jLω}{1 - LC {ω}^{2}} ,$
où j est l'imaginaire pur tel que j² = -1 et ω est la pulsation correspondant à la fréquence de commande non rayonnante choisie.

Ainsi, en choisissant judicieusement la valeur d'inductance L telle que L = 1/(Cω²), alors l'impédance Z est infinie à la fréquence non rayonnante choisie et le courant débité pour alimenter l'actionneur ou la portion de surface active d'actionneur est nul. En revanche, lorsque l'actionneur ou la portion de surface active d'actionneur n'est pas utilisé, il ou elle est court-circuité(e) en position b pour créer un shunt passif et dissiper l'énergie mécanique des vibrations résiduelles à travers la résistance 46.

Il apparaît clairement qu'un dispositif de modulation de friction localisée par vibrations tel que celui décrit précédemment permet de créer au moins un champ de vibrations localisées plus constant sollicitant plusieurs actionneurs, sans zone morte de transition entre les actionneurs sollicités lorsqu'ils sont voisins et se superposent. C'est très avantageux pour des applications de lubrification acoustique localisée ou de retour haptique localisé, mais également en micromanipulation par acoustophorèse.

On notera par ailleurs que l'invention n'est pas limitée aux modes de réalisation décrits précédemment.

En particulier, les motifs localisés de lubrification acoustique peuvent être prédéterminés sur la surface de contact 14, comme suggéré dans les exemples précédents. Mais ils peuvent aussi se déplacer temporellement en suivant un ou plusieurs doigts d'utilisateur lorsque ces interactions sont localisables par un système correspondant.

En variante également, les signaux de commande peuvent présenter des fréquences porteuses non rayonnantes différentes, notamment d'une zone de lubrification acoustique à une autre. Ils peuvent même chacun présenter plusieurs fréquences porteuses non rayonnantes.

Il apparaîtra plus généralement à l'homme de l'art que diverses modifications peuvent être apportées aux modes de réalisation décrits ci-dessus, à la lumière de l'enseignement qui vient de lui être divulgué. Dans la présentation détaillée de l'invention qui est faite précédemment, les termes utilisés ne doivent pas être interprétés comme limitant l'invention aux modes de réalisation exposés dans la présente description.

## Revendications

1. Dispositif (10) de modulation de friction localisée par vibrations, comportant :
- une interface vibrante (12) à surface de contact (14) ;
- plusieurs actionneurs (18₁, 18₂, 18₃, 18₄, 18₅, 18₆, 18₇, 18₈; 30₁, 30₂ ; 32₁, 32₂, 32₃; 38 ; 40) à surfaces actives, ces surfaces actives étant matérialisées pour chacun d'entre eux par la surface commune de leurs électrodes inférieure et supérieure en vis-à-vis et étant disposées contre l'interface vibrante (12), les actionneurs étant conçus pour mettre en vibration l'interface vibrante (12) dans une direction transversale par l'émission d'ondes mécaniques de flexion pour créer au moins une modulation de friction localisée sur la surface de contact (14) ; et
- un générateur (22) de plusieurs signaux (S₁, S₂, S₃, S₄, S₅, S₆, S₇, S₈) de commande des actionneurs (18₁, 18₂, 18₃, 18₄, 18₅, 18₅, 18₇, 18₆; 30₁, 30₂ ; 32₁, 32₂, 32₃ ; 38 ; 40) ;
chaque signal de commande (S₁, S₂, S₃, S₄, S₅, S₆, S₇, S₈) comportant un signal porteur à une fréquence non rayonnante pour l'actionneur (18₁, 18₂, 18₃, 18₄, 18₅, 18₅, 18₇, 18₈; 30₁, 30₂ ; 32₁, 32₂, 32₃ ; 38 ; 40) qu'il commande, c'est-à-dire à une fréquence engendrant, en dehors d'une zone de la surface de contact couverte par cet actionneur, des interférences destructrices des ondes mécaniques de flexion émises de sorte que l'amplitude des vibrations engendrées par cet actionneur en dehors de la zone couverte est inférieure d'au moins 10 dB à l'amplitude maximale des vibrations engendrées par cet actionneur dans la zone couverte ;
le dispositif étant **caractérisé en ce qu'**au moins deux des actionneurs (18₁, 18₂, 18₃, 18₄, 18₅, 18₆, 18₇, 18₈; 30₁, 30₂ ; 32₁, 32₂, 32₃ ; 38 ; 40) présentent une portion commune de leurs surfaces actives en superposition.

2. Dispositif (10) de modulation de friction localisée par vibrations selon la revendication 1, dans lequel les actionneurs (18₁, 18₂, 18₃, 18₄, 18₅, 18₆, 18₇, 18₈; 30₁, 30₂ ; 32₁, 32₂, 32₃; 40) sont disposés en un double pavage de leurs surfaces actives circulaires de même rayon R :
- un premier pavage matriciel (34) dans lequel chaque surface active touche sa ou ses voisine(s) en un point ;
- un deuxième pavage matriciel (36) identique mais superposé au premier (34) par décalage d'une distance égale au rayon R dans les deux directions en lignes et colonnes du premier pavage matriciel (34).

3. Dispositif (10) de modulation de friction localisée par vibrations selon la revendication 1, dans lequel les actionneurs (18₁, 18₂, 18₃, 18₄, 18₅, 18₆, 18₇, 18₈; 30₁, 30₂ ; 32₁, 32₂, 32₃ ; 38 ; 40) sont disposés en un triple pavage de leurs surfaces actives hexagonales de même longueur L de chaque côté d'hexagone :
- un premier pavage en nid d'abeilles dans lequel chaque surface active touche sa ou ses voisine(s) sur un côté ;
- deux autres pavages en nid d'abeilles identiques mais superposés au premier par décalage d'une distance égale à la longueur L dans deux des trois directions définies par les hexagones du premier pavage en nid d'abeilles.

4. Dispositif (10) de modulation de friction localisée par vibrations selon la revendication 2 ou 3, dans lequel la superposition de pavages constitue des portions de surfaces actives juxtaposées découpées dans une couche conductrice supérieure des actionneurs, chacune appartenant à un ou plusieurs actionneur(s) (18₁, 18₂, 18₃, 18₄, 18₅, 18₆, 18₇, 18₈ ; 30₁, 30₂ ; 32₁, 32₂, 32₃ ; 38 ; 40), et matérialisées par une couche d'électrodes à raison d'une électrode par portion de surface active, chaque électrode étant alimentée par la contribution additive du ou des signaux (S₁, S₂, S₃, S₄, S₅, S₆, S₇, S₈) de commande du ou des actionneur(s) (18₁, 18₂, 18₃, 18₄, 18₅, 18₆, 18₇, 18₈ ; 30₁, 30₂ ; 32₁, 32₂, 32₃; 38 ; 40) associé(s) à la portion de surface active qu'elle matérialise.

5. Dispositif (10) de modulation de friction localisée par vibrations selon la revendication 3, dans lequel :
- la superposition de pavages constitue des portions de surfaces actives juxtaposées découpées dans une couche conductrice supérieure des actionneurs, chacune appartenant à un ou plusieurs actionneur(s) (18₁, 18₂, 18₃, 18₄, 18₅, 18₆, 18₇, 18₈ ; 30₁, 30₂ ; 32₁, 32₂, 32₃; 38 ; 40), et matérialisées par une couche d'électrodes à raison d'une électrode par portion de surface active, chaque électrode étant alimentée par la contribution additive du ou des signaux (S₁, S₂, S₃, S₄, S₅, S₆, S₇, S₈) de commande du ou des actionneur(s) (18₁, 18₂, 18₃, 18₄, 18₅, 18₆, 18₇, 18₈ ; 30₁, 30₂ ; 32₁, 32₂, 32₃; 38 ; 40) associé(s) à la portion de surface active qu'elle matérialise ; et
- chaque portion de surface active est triangulaire, formant ainsi une découpe triangulaire régulière d'électrodes résultant de la superposition des trois pavages en nid d'abeilles, et appartient à au plus trois actionneurs hexagonaux centrés respectivement au plus sur ses trois sommets par chacun desquels elle est combinée à cinq autres portions de surfaces triangulaires pour former chaque actionneur auquel elle appartient.

6. Dispositif (10) de modulation de friction localisée par vibrations selon l'une quelconque des revendications 1 à 5, dans lequel au moins deux actionneurs (18₁, 18₂, 18₃, 18₄, 18₅, 18₅, 18₇, 18₈ ; 30₁, 30₂ ; 32₁, 32₂, 32₃; 38 ; 40) présentant une portion commune de leurs surfaces actives en superposition ont leurs signaux de commande (S₁, S₂, S₃, S₄, S₅, S₆, S₇, S₈) respectifs engendrés en opposition de phases.

7. Dispositif (10) de modulation de friction localisée par vibrations selon l'une quelconque des revendications 1 à 6, dans lequel le générateur (22) de signaux de commande (S₁, S₂, S₃, S₄, S₅, S₆, S₇, S₈) est conçu pour engendrer des signaux périodiques centrés fréquentiellement sur leur fréquence non rayonnante et modulés à basse fréquence selon au moins une fréquence de modulation inférieure ou égale à 1 kHz.

8. Dispositif (10) de modulation de friction localisée par vibrations selon l'une quelconque des revendications 1 à 7, dans lequel chaque actionneur (18₁, 18₂, 18₃, 18₄, 18₅, 18₆, 18₇, 18₈ ; 30₁, 30₂ ; 32₁, 32₂, 32₃; 38 ; 40) est couplé à un système de bascule (44) à shunt passif (46).

9. Dispositif (10) de modulation de friction localisée par vibrations selon l'une quelconque des revendications 1 à 8, dans lequel les actionneurs (18₁, 18₂, 18₃, 18₄, 18₅, 18₆, 18₇, 18₈; 30₁, 30₂ ; 32₁, 32₂, 32₃; 38 ; 40) comportent des transducteurs ultrasonores, notamment des transducteurs piézoélectriques ou magnétostrictifs.

10. Dispositif (10) de modulation de friction localisée par vibrations selon l'une quelconque des revendications 1 à 9, dans lequel l'interface vibrante (12) comporte une plaque d'écran à technologie de diodes électroluminescentes organiques

## Patentansprüche

1. Vorrichtung (10) zur lokalisierten Reibungsmodulation durch Schwingungen, die Folgendes aufweist:
- eine schwingende Schnittstelle (12) mit einer Kontaktfläche (14);
- mehrere Stellglieder (18₁, 18₂, 18₃, 18₄, 18₅, 18₆, 18₇, 18₈; 30₁, 30₂; 32₁, 32₂, 32₃; 38; 40) mit aktiven Oberflächen, wobei diese aktiven Oberflächen für jede von ihnen durch die gemeinsame Oberfläche ihrer unteren und oberen Elektroden gegenüberliegend materialisiert sind und an der schwingenden Schnittstelle (12) angeordnet sind, wobei die Stellglieder ausgebildet sind, um die schwingende Schnittstelle (12) durch die Emission mechanischer Biegewellen in einer Querrichtung in Schwingung zu versetzen, um mindestens eine auf der Kontaktfläche (14) lokalisierte Reibungsmodulation zu erzeugen; und
- einen Generator (22) für mehrere Signale (S₁, S₂, S₃, S₄, S₅, S₆, S₇, S₈) zur Steuerung der Stellglieder (18₁, 18₂, 18₃, 18₄, 18₅, 18₆, 18₇, 18₈; 30₁, 30₂; 32₁, 32₂, 32₃; 38; 40);
wobei jedes Steuersignal (S₁, S₂, S₃, S₄, S₅, S₆, S₇, S₈) ein Trägersignal mit einer nichtstrahlenden Frequenz für das Stellglied (18₁, 18₂, 18₃, 18₄, 18₅, 18₆, 18₇, 18₈; 30₁, 30₂; 32₁, 32₂, 32₃; 38; 40) aufweist, das es ansteuert, d. h. mit einer Frequenz, die außerhalb eines Bereichs der von diesem Stellglied abgedeckten Kontaktfläche destruktive Interferenzen der emittierten mechanischen Biegewellen verursacht, so dass die Amplitude der von diesem Stellglied außerhalb des abgedeckten Bereichs erzeugten Schwingungen mindestens 10 dB niedriger ist als die maximale Amplitude der von diesem Stellglied in dem abgedeckten Bereich erzeugten Schwingungen;
wobei die Vorrichtung **dadurch gekennzeichnet ist, dass** mindestens zwei der Stellglieder (18₁, 18₂, 18₃, 18₄, 18₅, 18₆, 18₇, 18₈; 30₁, 30₂; 32₁, 32₂, 32₃; 38; 40) einen gemeinsamen Abschnitt ihrer aktiven Flächen aufweisen, die einander überlagern.

2. Vorrichtung (10) zur lokalisierten Reibungsmodulation durch Schwingungen nach Anspruch 1, wobei die Stellglieder (18₁, 18₂, 18₃, 18₄, 18₅, 18₆, 18₇, 18₈; 30₁, 30₂; 32₁, 32₂, 32₃; 38; 40) in einer doppelten Kachelung ihrer kreisförmigen aktiven Flächen mit demselben Radius R angeordnet sind:
- eine erste Matrixkachelung (34), bei der jede aktive Fläche ihre(n) Nachbarn an einem Punkt berührt;
- eine zweite Matrixkachelung (36), die mit der ersten (34) identisch, dieser jedoch durch einen Versatz um einen Abstand, der gleich dem Radius R ist, in beiden Richtungen in Zeilen und Spalten der ersten Matrixkachelung (34) überlagert ist.

3. Vorrichtung (10) zur lokalisierten Reibungsmodulation durch Schwingungen nach Anspruch 1, wobei die Stellglieder (18₁, 18₂, 18₃, 18₄, 18₅, 18₆, 18₇, 18₈; 30₁, 30₂; 32₁, 32₂, 32₃; 38; 40) in einer dreifachen Kachelung ihrer sechseckigen aktiven Flächen mit gleicher Länge L auf jeder Seite des Sechskants angeordnet sind:
- eine erste Wabenkachelung, bei der jede aktive Fläche ihre(n) Nachbarn auf einer Seite berührt;
- zwei weitere Wabenkachelungen, die mit der ersten identisch, dieser jedoch durch einen Versatz um einen Abstand, der der Länge L entspricht, in zwei der drei Richtungen, die durch die Sechsecke der ersten Wabenkachelung definiert sind, überlagert sind.

4. Vorrichtung (10) zur lokalisierten Reibungsmodulation durch Schwingungen nach Anspruch 2 oder 3, wobei die Überlagerung von Kachelungen nebeneinanderliegende aktive Oberflächenabschnitte darstellt, die aus einer oberen leitenden Schicht der Stellglieder ausgeschnitten sind, von denen jeder zu einem oder mehreren Stellgliedern (18₁, 18₂, 18₃, 18₄, 18₅, 18₆, 18₇, 18₈; 30₁, 30₂; 32₁, 32₂, 32₃; 38; 40) gehört und durch eine Elektrodenschicht in Höhe einer Elektrode pro aktivem Oberflächenabschnitt materialisiert wird, wobei jede Elektrode durch den additiven Beitrag des oder der Signale (S₁, S₂, S₃, S₄, S₅, S₆, S₇, S₈) zur Ansteuerung des oder der Stellglieder (18₁, 18₂, 18₃, 18₄, 18₅, 18₆, 18₇, 18₈; 30₁, 30₂; 32₁, 32₂, 32₃; 38; 40) in Verbindung mit dem Abschnitt der aktiven Oberfläche, den sie materialisiert, mit Strom versorgt wird.

5. Vorrichtung (10) zur lokalisierten Reibungsmodulation durch Schwingungen nach Anspruch 3, wobei:
- die Überlagerung von Kachelungen nebeneinanderliegende aktive Flächenabschnitte darstellt, die aus einer oberen leitenden Schicht der Stellglieder ausgeschnitten sind, von denen jeder zu einem oder mehreren Stellgliedern (18₁, 18₂, 18₃, 18₄, 18₅, 18₆, 18₇, 18₈; 30₁, 30₂; 32₁, 32₂, 32₃; 38; 40) gehört und durch eine Elektrodenschicht in Höhe einer Elektrode pro aktivem Oberflächenabschnitt materialisiert wird, wobei jede Elektrode durch den additiven Beitrag des oder der Signale (S₁, S₂, S₃, S₄, S₅, S₆, S₇, S₈) zur Ansteuerung des oder der Stellglieder (18₁, 18₂, 18₃, 18₄, 18₅, 18₆, 18₇, 18₈; 30₁, 30₂; 32₁, 32₂, 32₃; 38; 40) in Verbindung mit dem aktiven Oberflächenabschnitt, den sie materialisiert, mit Strom versorgt wird; und
- jeder aktive Flächenabschnitt dreieckig ist, wodurch ein regelmäßiger dreieckiger Elektrodenabschnitt gebildet wird, der sich aus der Überlagerung der drei Wabenkachelungen ergibt, und zu höchstens drei sechseckigen Stellgliedern gehört, die jeweils höchstens auf seinen drei Spitzen zentriert sind, von denen jede mit fünf weiteren dreieckigen Flächenabschnitten kombiniert ist, um jedes Stellglied zu bilden, zu dem er gehört.

6. Vorrichtung (10) zur lokalisierten Reibungsmodulation durch Schwingungen nach einem der Ansprüche 1 bis 5, wobei bei mindestens zwei Stellgliedern (18₁, 18₂, 18₃, 18₄, 18₅, 18₆, 18₇, 18₈; 30₁, 30₂; 32₁, 32₂, 32₃; 38; 40), die einen gemeinsamen Abschnitt ihrer aktiven Flächen, die einander überlagern, aufweisen, ihre Steuersignale (S₁, S₂, S₃, S₄, S₅, S₆, S₇, S₈) jeweils mit einer Phasenverschiebung erzeugt werden.

7. Vorrichtung (10) zur lokalisierten Reibungsmodulation durch Schwingungen nach einem der Ansprüche 1 bis 6, wobei der Generator (22) für Steuersignale (S₁, S₂, S₃, S₄, S₅, S₆, S₇, S₈) ausgebildet ist, periodische Signale zu erzeugen, die frequenzmäßig auf ihre nichtstrahlende Frequenz zentriert und mit mindestens einer niedrigfrequenten Modulationsfrequenz von höchstens 1 kHz moduliert sind.

8. Vorrichtung (10) zur lokalisierten Reibungsmodulation durch Schwingungen nach einem der Ansprüche 1 bis 7, wobei jedes Stellglied (18₁, 18₂, 18₃, 18₄, 18₅, 18₆, 18₇, 18₈; 30₁, 30₂; 32₁, 32₂, 32₃; 38; 40) mit einem Wippsystem (44) mit passivem Shunt (46) gekoppelt ist.

9. Vorrichtung (10) zur lokalisierten Reibungsmodulation durch Schwingungen nach einem der Ansprüche 1 bis 8, wobei die Stellglieder (18₁, 18₂, 18₃, 18₄, 18₅, 18₆, 18₇, 18₈; 30₁, 30₂; 32₁, 32₂, 32₃; 38; 40) Ultraschallwandler aufweisen, insbesondere piezoelektrische oder magnetostriktive Wandler.

10. Vorrichtung (10) zur lokalisierten Reibungsmodulation durch Schwingungen nach einem der Ansprüche 1 bis 9, wobei die schwingende Schnittstelle (12) eine Bildschirmtafel aus organischen Leuchtdioden aufweist.

## Claims

1. A device (10) for local friction modulation via vibration, comprising:
- a vibrating interface (12) with a contact surface (14);
- a plurality of actuators (18₁, 18₂, 18₃, 18₄, 18₅, 18₆, 18₇, 18₈; 30₁, 30₂; 32₁, 32₂, 32₃; 38; 40) with active surfaces, these active surfaces being materialized for each of them by the common surface of their lower and upper electrodes facing each other and being arranged against the vibrating interface (12), the actuators being designed to vibrate the vibrating interface (12) in a transverse direction by emitting mechanical bending waves to create at least one local friction modulation on the contact surface (14); and
- a generator (22) of a plurality of control signals (S₁, S₂, S₃, S₄, S₅, S₆, S₇, S₈) for controlling the actuators (18₁, 18₂, 18₃, 18₄, 18₅, 18₆, 18₇, 18₈; 30₁, 30₂; 32₁, 32₂, 32₃; 38; 40);
each control signal (S₁, S₂, S₃, S₄, S₅, S₆, S₇, S₈) comprising a carrier signal at a non-radiating frequency for the actuator (18₁, 18₂, 18₃, 18₄, 18₅, 18₆, 18₇, 18₈; 30₁, 30₂; 32₁, 32₂, 32₃; 38; 40) that it controls, i.e. at a frequency generating, outside a zone of the contact surface covered by this actuator, destructive interference from the mechanical bending waves emitted, so that the amplitude of the vibrations generated by this actuator outside the covered zone is at least 10 dB less than the maximum amplitude of the vibrations generated by this actuator in the covered zone;
the device being **characterized in that** at least two of the actuators (18₁, 18₂, 18₃, 18₄, 18₅, 18₆, 18₇, 18₈; 30₁, 30₂; 32₁, 32₂, 32₃; 38; 40) share an overlapping common portion of their active surfaces.

2. The device (10) for local friction modulation via vibration according to claim 1, wherein the actuators (18₁, 18₂, 18₃, 18₄, 18₅, 18₆, 18₇, 18₈; 30₁, 30₂; 32₁, 32₂, 32₃; 40) are arranged in a double tiling of their circular active surfaces of equal radius R:
- a first matrix tiling (34) wherein each active surface touches its neighbor(s) at a point;
- a second matrix tiling (36) identical to but overlapped with the first matrix tiling (34) by shifting a distance equal to the radius R in both row and column directions of the first matrix tiling (34).

3. The device (10) for local friction modulation via vibration according to claim 1, wherein the actuators (18₁, 18₂, 18₃, 18₄, 18₅, 18₆, 18₇, 18₈; 30₁, 30₂; 32₁, 32₂, 32₃; 38; 40) are arranged in a triple tiling of their hexagonal active surfaces of equal length L of each hexagon side:
- a first honeycomb tiling wherein each active surface touches its neighbor(s) on one side;
- two other honeycomb tilings identical but overlapped with the first honeycomb tiling by shifting a distance equal to the length L in two of the three directions defined by the hexagons of the first honeycomb tiling.

4. The device (10) for local friction modulation via vibration according to claim 2 or 3, wherein the tiling overlapping constitutes juxtaposed active surface portions cut out in an upper conductive layer of actuators, each belonging to one or more actuator(s) (18₁, 18₂, 18₃, 18₄, 18₅, 18₆, 18₇, 18₈; 30₁, 30₂; 32₁, 32₂, 32₃; 38; 40), and materialized by a layer of electrodes, one per active surface portion, each electrode being supplied by an additive contribution of the control signal(s) (S₁, S₂, S₃, S₄, S₅, S₆, S₇, S₈) of the actuator(s) (18₁, 18₂, 18₃, 18₄, 18₅, 18₆, 18₇, 18₈; 30₁, 30₂; 32₁, 32₂, 32₃; 38; 40) associated with the active surface portion it materializes.

5. The device (10) for local friction modulation via vibration according to claim 3, wherein:
- the tiling overlapping constitutes juxtaposed active surfaces portions cut out in an upper conductive layer of actuators, each belonging to one or more actuator(s) (18₁, 18₂, 18₃, 18₄, 18₅, 18₆, 18₇, 18₈; 30₁, 30₂; 32₁, 32₂, 32₃; 38; 40), and materialized by a layer of electrodes, one per active surface portion, each electrode being supplied by an additive contribution of the control signal(s) (S₁, S₂, S₃, S₄, S₅, S₆, S₇, S₈) of the actuator(s) (18₁, 18₂, 18₃, 18₄, 18₅, 18₆, 18₇, 18₈; 30₁, 30₂; 32₁, 32₂, 32₃; 38; 40) associated with the active surface portion it materializes; and
- each active surface portion is triangular, thus forming a regular triangular cutout of electrodes resulting from the overlapping of the three honeycomb tilings, and belongs to at most three hexagonal actuators centered respectively at most on its three vertices, through each of which it is combined with five other triangular surface portions to form each actuator to which it belongs.

6. The device (10) for local friction modulation via vibration according to any of claims 1 to 5, wherein at least two actuators (18₁, 18₂, 18₃, 18₄, 18₅, 18₆, 18₇, 18₈; 30₁, 30₂; 32₁, 32₂, 32₃; 38; 40) sharing an overlapping common portion of their active surfaces have their respective control signals (S₁, S₂, S₃, S₄, S₅, S₆, S₇, S₈) generated in phase opposition.

7. The device (10) for local friction modulation via vibration according to any of claims 1 to 6, wherein the generator (22) of control signals (S₁, S₂, S₃, S₄, S₅, S₆, S₇, S₈) is designed to generate periodic signals frequency-centered on their non-radiating frequency and modulated at low frequency according to at least one modulation frequency less than or equal to 1 kHz.

8. The device (10) for local friction modulation via vibration according to any of claims 1 à 7, wherein each actuator (18₁, 18₂, 18₃, 18₄, 18₅, 18₆, 18₇, 18₈; 30₁, 30₂; 32₁, 32₂, 32₃; 38; 40) is coupled to a passive shunt (46) flip-flop system (44).

9. The device (10) for local friction modulation via vibration according to any of claims 1 to 8, wherein the actuators (18₁, 18₂, 18₃, 18₄, 18₅, 18₆, 18₇, 18₈; 30₁, 30₂; 32₁, 32₂, 32₃; 38; 40) comprise ultrasonic transducers, in particular piezoelectric or magnetostrictive transducers.

10. The device (10) for local friction modulation via vibration according to any of claims 1 to 9, wherein the vibrating interface (12) comprises a display plate with organic light-emitting diode technology.
